# EUROPEAN PATENT APPLICATION

(11) **EP 3 521 769 A1**
(43) Date of publication of application: **07.08.2019**
(21) Application number: 18199536.6
(22) Date of filing: 10.10.2018
(51) Int. Cl.: G01D 18/00

(54) **CONTROL APPARATUS AND CONTROL METHOD**

(30) Priority: 31.01.2018 JP 2018015800
(71) Applicant: OMRON CORPORATION, Kyoto-shi, Kyoto 600-8530 (JP)
(72) Inventor: OBA, Hitoshi, KYOTO, 600-8530 (JP); TAKAHASHI, Minoru, KYOTO, 600-8530 (JP)
(74) Representative: Becker Kurig Straus

(57) **Abstract**

According to the disclosure, it is possible to perform comparison with high accuracy even if a deviation in the time axis direction occurs between the target signal and the comparison condition. A control apparatus (3) includes an acquisition part (32) acquiring a time series signal output from a device; a comparison condition storage part (34) storing information indicating a temporal change of a predetermined comparison condition; an area determination part (374) determining a target area, which is an area satisfying a predetermined condition indicating that change of a value is stable, in the signal acquired by the acquisition part (32); and a comparison part (375) performing comparison with the comparison condition by using a signal of the target area determined by the area determination part (374).

## Description

### BACKGROUND

### Technical Field

The disclosure relates to a control apparatus and a control method.

### Description of Related Art

Apparatuses that perform various processes by using signals output from devices such as sensors and motors have been proposed. For example, Patent Document 1 discloses a technique of applying a predetermined incident wave to a substrate under measurement and determining the quality of the substrate under measurement based on the result of comparing the obtained reflected waveform with the standard waveform.

### Related Art

### Patent Document

[Patent Document 1] Japanese Laid-open No. 2009-287943

### SUMMARY

### Problem to be Solved

When performing such processing, it is necessary to acquire a signal of a time interval (hereinafter, referred to as "target signal") used for the actual determination process from the time series signals output from the devices such as sensors and motors. However, a deviation in the time direction may occur between the acquired target signal (for example, the aforementioned reflected waveform) and the signal to be compared (for example, the aforementioned standard waveform). In such cases, the target signal that should actually be determined as "acceptable" may be determined as "unacceptable" due to the deviation in the time direction. Conversely, the target signal that should actually be determined as "unacceptable" may be determined as "acceptable". Such a problem is not specific to the case of comparing the target signal with other signals and may occur generally when the target signal is compared with a condition that varies with time (hereinafter, referred to as "comparison condition"). Thus, the accuracy of the comparison process may change due to the deviation in the time axis direction between the target signal and the comparison condition.

The disclosure has been made in view of the above points and aims to provide a control apparatus and a control method, which make it possible to perform comparison with high accuracy even if a deviation in the time axis direction occurs between the target signal and the comparison condition.

### Solution to the Problem

According to one aspect of the disclosure, a control apparatus includes an acquisition part acquiring a time series signal output from a device; a comparison condition storage part storing information indicating a temporal change of a predetermined comparison condition; an area determination part determining a target area, which is an area satisfying a predetermined condition indicating that change of a value is stable, in the signal acquired by the acquisition part; and a comparison part performing comparison with the comparison condition by using a signal of the target area determined by the area determination part.

According to one aspect of the disclosure, in the above control apparatus, the area determination part determines an area between a point of time at which a predetermined first time has elapsed since a beginning of the signal and a point of time at which a predetermined second time has elapsed since the beginning of the signal as the target area.

According to one aspect of the disclosure, in the above control apparatus, the area determination part determines an area from a point of time at which a condition indicating that change of the value of the signal is stable is satisfied for a predetermined time to a point of time at which the predetermined time has elapsed as the target area.

According to one aspect of the disclosure, in the above control apparatus, the area determination part determines an area from a point of time at which a condition indicating that change of the value of the signal is stable is satisfied for a predetermined time to a point of time at which the condition is not satisfied as the target area.

According to one aspect of the disclosure, a control method is provided for an apparatus, which includes a comparison condition storage part that stores information indicating a temporal change of a predetermined comparison condition, to execute: an acquisition step of acquiring a time series signal output from a device; an area determination step of determining a target area, which is an area satisfying a predetermined condition indicating that change of a value is stable, in the signal acquired in the acquisition step; and a comparison step of performing comparison with the comparison condition by using a signal of the target area determined in the area determination step.

### Effects

According to the disclosure, comparison can be performed with high accuracy even if a deviation in the time axis direction occurs between the target signal and the comparison condition.

### BRIEF DESCRIPTION OF THE DRAWINGS

FIG. 1 is a diagram showing a specific example of the configuration of the control system 100.
FIG. 2 is a block diagram showing a specific example of the functional configuration of the control apparatus 3 according to the first embodiment.
FIG. 3 is a flowchart showing an operation example of the control apparatus 3 according to the first embodiment.
FIG. 4 is a diagram showing the first specific example of the area condition.
FIG. 5 is a diagram showing the second specific example of the area condition.
FIG. 6 is a diagram showing the third specific example of the area condition.
FIG. 7 is a diagram showing the configuration of the control system 100 according to a modified example.
FIG. 8 is a block diagram showing a specific example of the functional configuration of the control apparatus 3 according to the second embodiment.
FIG. 9 is a flowchart showing an operation example of the control apparatus 3 according to the second embodiment.
FIG. 10 is a diagram showing a specific example of the comparison pattern.
FIG. 11 is a diagram showing a specific example of the target signal.
FIG. 12 is a diagram showing the comparison pattern and an unshifted target signal arranged on the same time axis.
FIG. 13 is a diagram showing the comparison pattern and a shifted target signal arranged on the same time axis.

### DESCRIPTION OF THE EMBODIMENTS

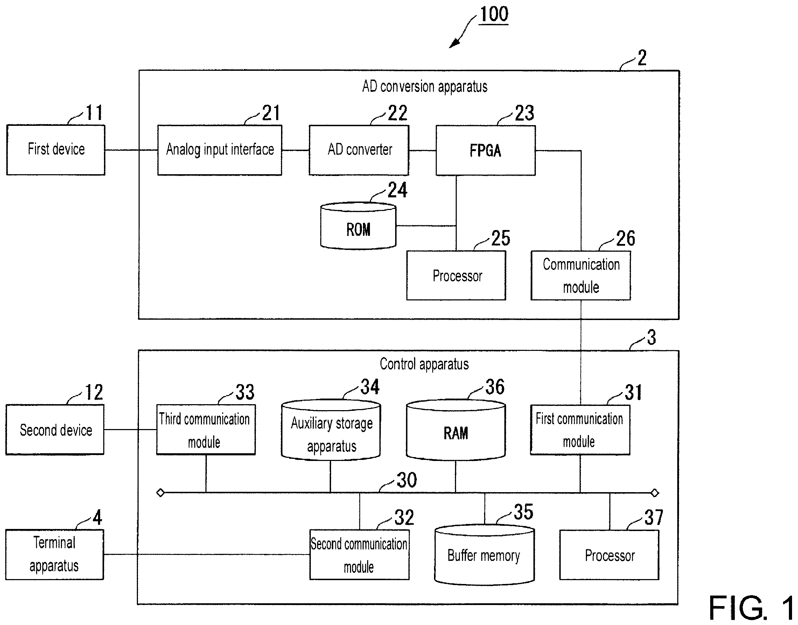

FIG. 1 is a diagram showing a specific example of the configuration of a control system 100. The control system 100 includes a first device 11, a second device 12, an AD conversion apparatus 2, a control apparatus 3, and a terminal apparatus 4.

The first device 11 is an input device such as a temperature sensor or a pressure sensor, or an output device such as a servo motor. If the first device 11 is an input device, the first device 11 outputs a value obtained as a result of sensing. If the first device 11 is an output device, the first device 11 outputs a value indicating the content of an operation, the state after the operation, etc. The first device 11 is connected to the AD conversion apparatus 2. The first device 11 outputs an electric signal indicating an analog value to the AD conversion apparatus 2.

The second device 12 is an input device such as a temperature sensor or a pressure sensor, or an output device such as a servo motor. The second device 12 is configured as a device different from the first device 11. For example, if the first device 11 is a distance sensor used for measuring the surface shape of an object under measurement (hereinafter, referred to as "target object"), the second device 12 may be a detection device for detecting the position of the target object that is to be conveyed. For example, if the first device 11 is a temperature sensor used for measuring the temperature of a space under measurement (hereinafter, referred to as "target space"), the second device 12 may be a device for measuring the illuminance of the target space or a device for detecting a person existing in the target space. For example, if the first device 11 is a drive device of a conveyor for conveying an object to be conveyed (hereinafter, referred to as "conveyance body"), the second device 12 may be a detection device for detecting the position of the conveyed object. Thus, the second device 12 is a device that senses or acts on a target sensed or acted on by the first device 11, or a target related thereto.

The AD conversion apparatus 2 is connected to the first device 11 and inputs a time series analog signal output from the first device 11 to the apparatus itself. The AD conversion apparatus 2 converts the analog signal into a digital signal and outputs the converted digital signal to the control apparatus 3.

The control apparatus 3 is configured by using an information processing apparatus. The control apparatus 3 is, for example, a PLC (programmable logic controller). The control apparatus 3 is connected to the AD conversion apparatus 2 and inputs time series digital signals sequentially output from the AD conversion apparatus 2 to the apparatus itself. When a predetermined condition (recording start condition) is satisfied, the control apparatus 3 starts a recording operation for the digital signals output from the AD conversion apparatus 2. When a predetermined condition (recording end condition) is satisfied, the control apparatus 3 ends the recording operation for the digital signals output from the AD conversion apparatus 2. The control apparatus 3 records in an internal memory the information indicating the digital signals that are input from the start to the end of the recording operation as information of a target signal. The control apparatus 3 compares the target signal recorded in the internal memory with a preset comparison condition. The control apparatus 3 performs determination with respect to the target signal according to the comparison result. The control apparatus 3 may record the determination result in the internal memory or may output it to another apparatus.

The terminal apparatus 4 is an information processing apparatus such as a PC (personal computer) or a workstation, a smartphone, a mobile phone, a tablet terminal, etc. The terminal apparatus 4 is configured to be able to communicate with the control apparatus 3. The terminal apparatus 4 is used for a user of the control system 100 to input various operations to the control apparatus 3.

Next, the configuration of the AD conversion apparatus 2 and the control apparatus 3 will be described in detail. First, the hardware configuration of each apparatus will be described with reference to FIG. 1.

First, the hardware configuration of the AD conversion apparatus 2 will be described. The AD conversion apparatus 2 includes an analog input interface 21, an AD converter 22, an FPGA (field programmable gate array) 23. a ROM (read only memory) 24, a processor 25, and a communication module 26.

The analog input interface 21 is an input interface for analog signals. The analog input interface 21 connects the first device 11 and the AD conversion apparatus 2 and inputs the time series analog signals output from the first device 11 to the AD conversion apparatus 2.

The AD converter 22 converts the analog signal input via the analog input interface 21 into a digital signal. Specifically, the AD converter 22 samples the analog signal in a sampling cycle of about several microseconds and converts the sampled analog signal into a digital signal by quantizing it at a predetermined quantization level.

The FPGA 23 is a circuit that performs arithmetic processing on the digital signal converted by the AD converter 22. Specific examples of arithmetic processing include digital filter processing, offset/span setting processing, etc. Specific examples of digital filter processing include processing of smoothing using low pass filter or moving average. The digital signal that has undergone the arithmetic processing is transmitted to the control apparatus 3 via the communication module 26.

Specifically, the AD conversion apparatus 2 stores configuration data for configuring the FPGA 23 as a circuit that performs arithmetic processing in the ROM 24 in advance. The FPGA 23 acquires from the processor 25 the configuration data read from the ROM 24 at the time of activation of the AD conversion apparatus 2 and performs configuration processing (generally referred to as configuration) of a logic circuit based on the acquired configuration data to thereby configure itself as a circuit that performs arithmetic processing.

The communication module 26 is a communication interface for the AD conversion apparatus 2 to communicate with the control apparatus 3. The communication module 26 is connected to a first communication module 31 of the control apparatus 3 and transmits the digital signal that has undergone arithmetic processing performed by the FPGA 23 to the control apparatus 3.

Next, the hardware configuration of the control apparatus 3 will be described. The control apparatus 3 includes the first communication module 31, a second communication module 32, a third communication module 33, an auxiliary storage apparatus 34, a buffer memory 35, a RAM (random access memory) 36, and a processor 37 connected by an internal bus 30.

The first communication module 31 is a communication interface for the control apparatus 3 to communicate with the AD conversion apparatus 2. The first communication module 31 is connected to the communication module 26 of the AD conversion apparatus 2 and receives the digital signal transmitted from the AD conversion apparatus 2. The digital signal received by the first communication module 31 is stored in the buffer memory 35.

The second communication module 32 is a communication interface for the control apparatus 3 to communicate with the terminal apparatus 4. The second communication module 32 is connected to a communication interface of the terminal apparatus 4 and performs transmission and reception of various information with the terminal apparatus 4.

The third communication module 33 is a communication interface for the control apparatus 3 to communicate with the second device 12. The third communication module 33 is connected to a communication interface of the second device 12 and receives a signal transmitted from the second device 12. The signal received by the third communication module 33 is a signal converted into a digital signal by the second device 12 or an AD conversion apparatus (not shown). The third communication module 33 may be an interface of a network such as EtherCAT (registered trademark), for example.

The auxiliary storage apparatus 34 is configured by using a storage apparatus such as a magnetic hard disk apparatus or a semiconductor storage apparatus. The auxiliary storage apparatus 34 stores various setting information necessary for the operation of the control apparatus 3 or various information acquired or generated in the control apparatus 3.

The buffer memory 35 stores values of the digital signals received by the first communication module 31 from the AD conversion apparatus 2. The buffer memory 35 repeatedly executes storing and erasing of digital signal values at a predetermined operation cycle. By accessing the buffer memory 35 in synchronization with the operation cycle, the processor 37 can read the digital signal values stored in the buffer memory 35 and record them in the RAM 36.

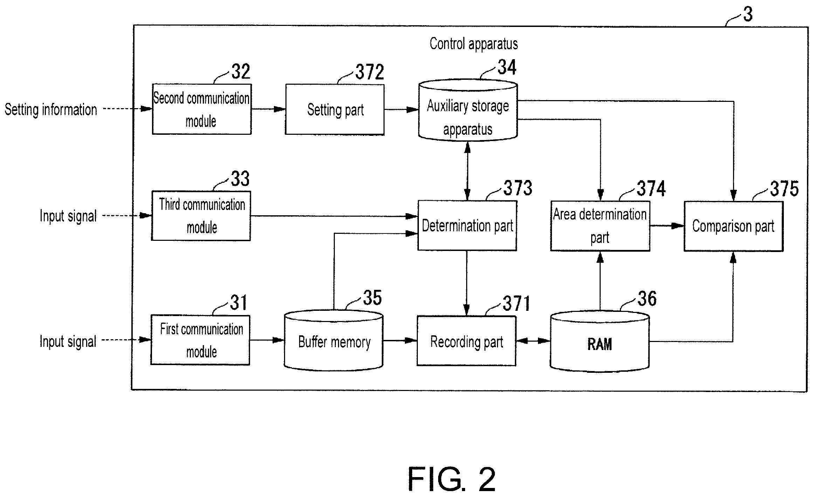

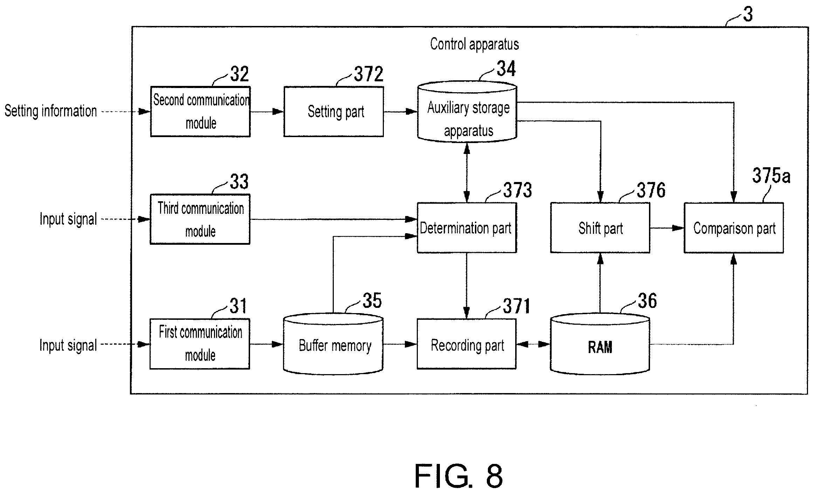

The RAM 36 and the processor 37 execute various processes for realizing the operation of the control apparatus 3. Specifically, the processor 37 reads the program stored in the auxiliary storage apparatus 34 into the RAM 36 and executes the program. By executing the program, the control apparatus 3 functions as an apparatus having the functional configuration shown in FIG. 2 or FIG. 8 and performs the recording operation or comparison operation on the digital signal value by the operation of each functional part shown in FIG. 2 or FIG. 8.

### [First Embodiment]

FIG. 2 is a block diagram showing a specific example of the functional configuration of the control apparatus 3 according to the first embodiment. The control apparatus 3 according to the first embodiment functions as an apparatus including a recording part 371, a setting part 372, a determination part 373, an area determination part 374, and a comparison part 375 through execution of the program performed by the processor 37. All or a part of the functions of the control apparatus 3 may be realized by using hardware such as an ASIC (application specific integrated circuit), a PLD (programmable logic device), an FPGA, and the like. The program may be recorded in a computer readable recording medium. The computer readable recording medium is, for example, a movable medium such as a flexible disk, a magneto-optical disk, a ROM, a CD-ROM, and the like, or a storage apparatus such as a hard disk incorporated in a computer system. The program may be transmitted via an electric communication line.

The recording part 371 acquires the digital signal value stored in the buffer memory 35 and stores the acquired digital signal value in the RAM 36 (a specific example of the signal information recording part). Hereinafter, the operation in which the recording part 371 stores the digital signal value acquired from the buffer memory 35 in the RAM 36 is referred to as a recording operation. The recording part 371 starts the recording operation at a timing determined by the determination part 373. The recording part 371 ends the recording operation at a timing determined by the determination part 373. The target signal is recorded in the RAM 36 by the recording operation of the recording part 371.

The setting part 372 registers various settings related to the operation of the control apparatus 3. More specifically, the setting part 372 communicates with the terminal apparatus 4 via the second communication module 32 and acquires information necessary for registering various settings from the terminal apparatus 4. The setting part 372 registers various settings for the control apparatus 3 by generating setting information based on the information acquired from the terminal apparatus 4 and storing the generated setting information in the auxiliary storage apparatus 34. If the setting information is registered in advance in the auxiliary storage apparatus 34, the setting part 372 may update the setting information based on the information acquired from the terminal apparatus 4.

For example, the setting part 372 receives from the terminal apparatus 4 information indicating a condition (hereinafter, referred to as a "recording start condition") at the time when the recording part 371 starts a recording operation and records the information in the auxiliary storage apparatus 34 as setting information. For example, the setting part 372 receives from the terminal apparatus 4 information indicating a condition (hereinafter, referred to as a "recording end condition") at the time when the recording part 371 ends the recording operation and records the information in the auxiliary storage apparatus 34 as setting information. There are a plurality of patterns of the recording start condition and the recording end condition that can be set in the setting part 372. From the plurality of patterns, the user can select a desired pattern corresponding to the control system 100 as the setting condition. In the following description, a configuration in which a user can select a desired pattern as the recording start condition and the recording end condition from the plurality of patterns is referred to as an "intelligent trigger".

The recording start condition may be set as a timing at which a digital value (hereinafter, referred to as a "first signal value") received by the first communication module 31 exceeds a predetermined threshold value, for example. In this case, the recording end condition may be set as a timing at which the first signal value drops below a predetermined threshold value, for example. The threshold value used in the recording start condition and the threshold value used in the recording end condition may be the same value or different values. Such a pattern is one of the conditions that may be selected as an intelligent trigger.

The recording start condition may be set as a timing at which a digital value (hereinafter, referred to as a "second signal value") received by the third communication module 33 satisfies a predetermined condition, for example. The recording end condition may be set as a timing at which the second signal value satisfies a predetermined condition, for example. More specifically, the recording start condition may be set as a timing at which the second signal value becomes a value indicating ON, for example. In this case, the recording end condition may be set as a timing at which the second signal value becomes a value indicating OFF. Such a pattern is one of the conditions that may be selected as an intelligent trigger. Nevertheless, the above-described recording start condition and recording end condition are merely one example. The recording start condition and the recording end condition registered as setting information in the control apparatus 3 may be defined as any condition.

The determination part 373 determines the timing at which the recording part 371 starts the recording operation and the timing at which the recording part 371 ends the recording operation based on the setting information set by the setting part 372.

The area determination part 374 determines an area (hereinafter, referred to as "target area") to be used for the comparison process performed by the comparison part 375 out of the waveform of the target signal. The area determination part 374 determines the area of a portion that satisfies an area condition included in the setting information preset in the auxiliary storage apparatus 34 as the target area. The area condition is a condition indicating that the change of the value of the target signal is stable. Thus, the area determination part 374 determines the area where the change of the value of the target signal is stable as the target area. The specific operation of the area determination part 374 will be described later.

The comparison part 375 compares the signal of the target area with the comparison condition. The comparison condition is information included in the setting information that is preset in the auxiliary storage apparatus 34 (a specific example of the comparison condition storage part). The comparison condition is expressed as a combination of time and signal value with respect to the target signal. The comparison condition may be expressed as a threshold value of a predetermined time interval of the target signal, for example. The comparison condition may be expressed as a threshold value that varies with time with respect to the target signal, for example. The comparison part 375 acquires the comparison condition corresponding to the time interval of the target area determined by the area determination part 374 and compares the target area with the comparison condition. For example, if the target area is determined as the time from a time tm to a time tn with the time at which the recording start condition is satisfied as the starting point, the comparison part 375 performs comparison using the comparison condition corresponding to the time from the time tm to the time tn.

The comparison condition is set as a condition corresponding to the determination process performed by the control apparatus 3 with respect to the target signal. For example, if determination of the quality of the target signal is performed by the control apparatus 3, a condition indicating one or both of "acceptable" and "unacceptable" may be preset as the comparison condition. For example, if a process of determining the start timing of another process according to the target signal is performed by the control apparatus 3, a condition indicating that it is the start timing may be preset as the comparison condition.

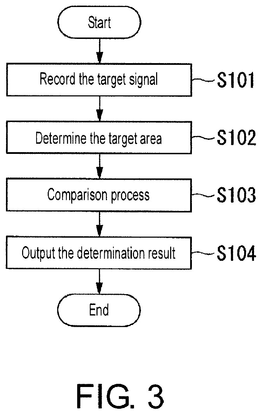

FIG. 3 is a flowchart showing an operation example of the control apparatus 3 according to the first embodiment. The flowchart shown in FIG. 3 shows a flow of the processing at the time when the control apparatus 3 performs the comparison process. First, the recording part 371 executes the recording operation according to the recording start condition and the recording end condition stored in the auxiliary storage apparatus 34 (step S101). By executing the recording operation, the target signal is recorded in the RAM 36. The area determination part 374 determines the target area in the target signal according to the area condition stored in the auxiliary storage apparatus 34 (step S102). The comparison part 375 compares the determined target area with the comparison condition stored in the auxiliary storage apparatus 34 (step S103). The comparison part 375 performs the determination process according to the comparison result. The comparison part 375 outputs a determination result (step S104).

### (First Specific Example)

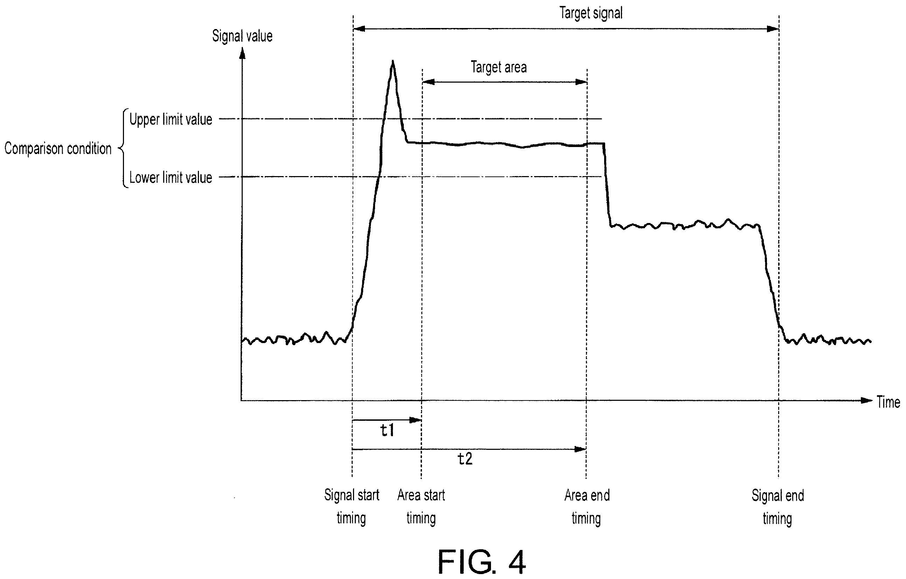

FIG. 4 is a diagram showing the first specific example of the area condition. The waveform shown in FIG. 4 is a specific example of the signal waveform indicating the time series change of the value (signal value) of the target signal. In FIG. 4, the signal waveform from the signal start timing to the signal end timing is the waveform of the target signal. The signal start timing indicates a timing at which the recording start condition is satisfied. The signal end timing indicates a timing at which the recording end condition is satisfied.

The area condition includes a start condition indicating the start timing of the target area (hereinafter, referred to as "area start timing") and an end condition indicating the end timing of the target area (hereinafter, referred to as "area end timing"). In the first specific example, the start condition indicates a timing at which a predetermined time t1 has elapsed since the signal start timing. In the first specific example, the end condition indicates a timing at which a predetermined time t2 has elapsed since the signal start timing. In this case, the area determination part 374 determines the area between the timing at which the predetermined time t1 has elapsed since the signal start timing (the beginning of the signal) of the target signal and the timing at which the predetermined time t2 has elapsed since the signal start timing of the target signal as the target area. In this case, the comparison part 375 compares the signal value from the area start timing to the area end timing with the comparison condition from the area start timing to the area end timing (for example, the signal value falls between the upper limit value and the lower limit value). In the example of FIG. 4, since the signal value of the target area is equal to or greater than the lower limit value and less than the upper limit value, it is determined that the comparison condition is satisfied.

In the first specific example, the values of the predetermined time t1 and the predetermined time t2, i.e., the area condition, may be obtained by analyzing the target signal in advance. For example, a target signal that satisfies the comparison condition (hereinafter, referred to as "teacher signal") may be acquired, the times from the beginning portion of the teacher signal to the beginning portion and the end portion of the area where the value change is stable (area that satisfies the area condition) may be measured, and the measurement results may be defined as the predetermined time t1 and the predetermined time t2 respectively. The predetermined time t1 and the predetermined time t2 may be obtained based on a plurality of teacher signals. For example, the predetermined time t1 and the predetermined time t2 may be defined based on the statistics of the measurement results obtained in multiple teacher signals.

### (Second Specific Example)

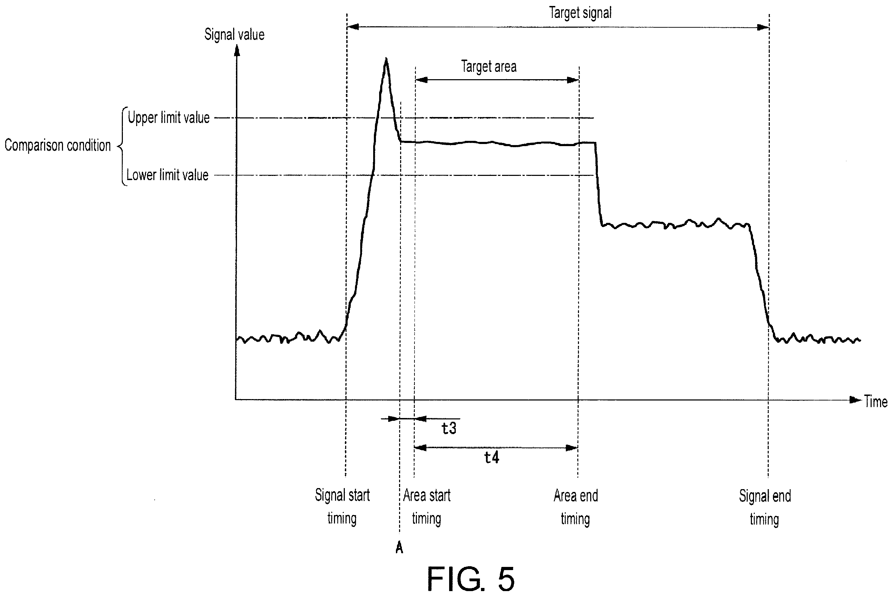

FIG. 5 is a diagram showing the second specific example of the area condition. The waveform shown in FIG. 5 is the same as the waveform shown in FIG. 4.

In the second specific example, the start condition is that the change of the value of the target signal is stable for a predetermined time t3 after the signal start timing. The condition indicating that the change of the value of the target signal is stable may be, for example, that the difference between the maximum value and the minimum value of the signal value is equal to or less than a predetermined value or that the distribution of the signal value is equal to or less than a predetermined value, or may be indicated by other conditions. If the change of the value of the target signal is stable for the predetermined time t3, the area determination part 374 determines the timing at which the predetermined time t3 has elapsed as the area start timing.

In the second specific example, the end condition indicates the timing at which a predetermined time t4 has elapsed since the area start timing. In this case, the area determination part 374 determines the area between the area start timing determined by the above-described process and the timing at which the predetermined time t4 has elapsed since the area start timing as the target area.

In the second specific example, the values of the predetermined time t3 and the predetermined time t4, i.e., the area condition, may be obtained by analyzing the target signal in advance. For example, a teacher signal may be acquired, the length of the time when the signal value is stable required for rendering the area satisfying the area condition may be measured based on the area satisfying the area condition and the area not satisfying the area condition, and the predetermined time t3 may be defined based on the measurement result. Further, the length of the time for the area condition to be satisfied after the area start timing may be measured, and the predetermined time t4 may be defined based on the measurement result. The predetermined time t3 and the predetermined time t4 may be obtained based on a plurality of teacher signals. For example, the predetermined time t3 and the predetermined time t4 may be defined based on the statistics of the measurement results obtained in multiple teacher signals.

In the specific example of FIG. 5, if the change of the value of the target signal is stable for the predetermined time t3, the timing at which the predetermined time t3 has elapsed is defined as the area start timing. However, the start timing of the predetermined time t3 (the timing indicated by A in FIG. 5) may be defined as the area start timing.

### (Third Specific Example)

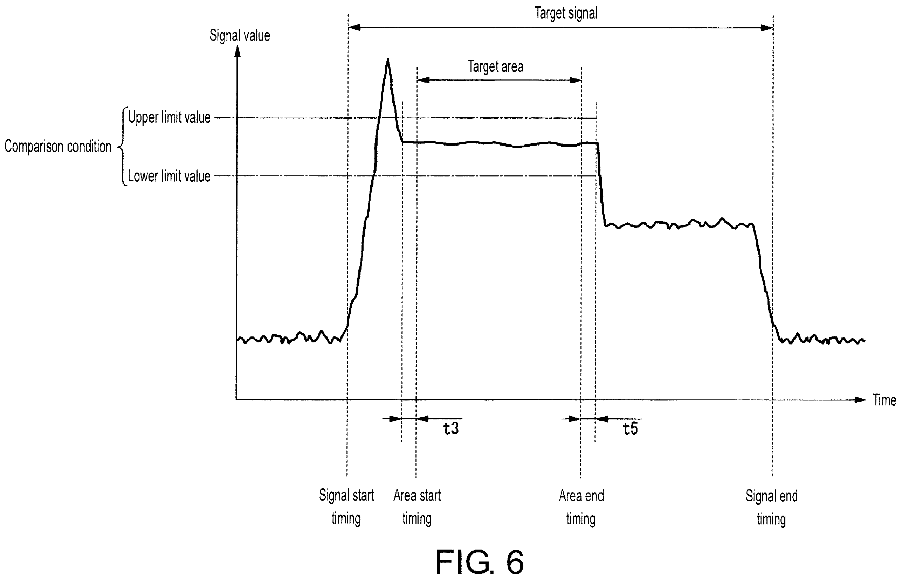

FIG. 6 is a diagram showing the third specific example of the area condition. The waveform shown in FIG. 6 is the same as the waveform shown in FIG. 5.

The start condition in the third specific example is the same as the start condition in the second specific example. However, the end condition in the third specific example is different from the end condition in the second specific example. The end condition in the third specific example will be described below.

The end condition in the third specific example is that the change of the value of the target signal becomes unstable for the first time in the predetermined time t5 after the area start timing. The condition indicating that the change of the value of the target signal becomes unstable may be, for example, that the difference between the maximum value and the minimum value of the signal value is equal to or greater than a predetermined value or that the distribution of the signal value is equal to or greater than a predetermined value, or may be indicated by other conditions. If the change of the value of the target signal becomes unstable during the predetermined time t5, the area determination part 374 determines the start timing of the predetermined time t5 as the area end timing.

In the third specific example, the value of the predetermined time t5, i.e., the area condition, may be obtained by analyzing the target signal in advance. For example, a teacher signal may be acquired, the length of the time when the signal value is stable required for rendering the area satisfying the area condition may be measured based on the area satisfying the area condition and the area not satisfying the area condition, and the predetermined time t5 may be defined based on the measurement result. The predetermined time t5 may be obtained based on a plurality of teacher signals. For example, the predetermined time t5 may be defined based on the statistics of the measurement results obtained in multiple teacher signals.

In the control apparatus 3 according to the first embodiment configured as described above, a waveform satisfying the area condition, i.e., the condition indicating that the change of the value of the target signal is stable, is determined as the waveform to be used for the comparison process of the comparison part 375. Since the comparison is performed with the portion where the waveform change is small, even if the target signal and the comparison condition deviate in the time axis direction, the influence of the deviation in the time axis direction can be reduced. Therefore, the comparison can be performed with high accuracy.

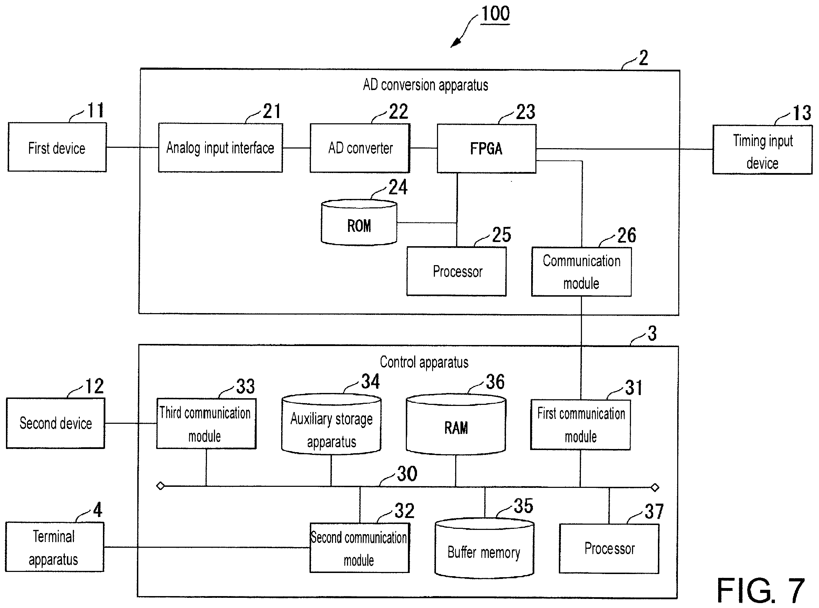

FIG. 7 is a diagram showing the configuration of the control system 100 according to a modified example. As shown in FIG. 7, in the control system 100, a timing input device 13 may be connected to the AD conversion apparatus 2. The timing input device 13 is, for example, a timing sensor or a mechanical switch. The timing input device 13 detects the presence of the target object in a predetermined area. The timing input device 13 outputs a digital signal (ON signal or OFF signal) indicating the detection result to the AD conversion apparatus 2. The AD conversion apparatus 2 outputs the digital signal output from the timing input device 13 to the control apparatus 3. The digital signal output by the timing input device 13 may be used in the control apparatus 3 to determine the timing of starting the recording operation of the digital signal with respect to the target object. In other words, the determination part 373 of the control apparatus 3 may determine the timing to start or the timing to end the recording operation based on the digital signal output from the timing input device 13.

### [Second Embodiment]

FIG. 8 is a block diagram showing a specific example of the functional configuration of the control apparatus 3 according to the second embodiment. The control apparatus 3 according to the second embodiment functions as an apparatus including a recording part 371, a setting part 372, a determination part 373, a comparison part 375a, and a shift part 376 through execution of the program performed by the processor 37. All or a part of the functions of the control apparatus 3 may be realized by using hardware such as an ASIC, a PLD, an FPGA, and the like. The program may be recorded in a computer readable recording medium. The computer readable recording medium is, for example, a movable medium such as a flexible disk, a magneto-optical disk, a ROM, a CD-ROM, and the like, or a storage apparatus such as a hard disk incorporated in a computer system. The program may be transmitted via an electric communication line.

The recording part 371, the setting part 372, and the determination part 373 in the second embodiment are the same as the functional parts with the same names in the first embodiment. Therefore, the description of the recording part 371, the setting part 372, and the determination part 373 will be omitted.

The shift part 376 acquires the signal waveform to be used for the comparison process performed by the comparison part 375a by shifting the waveform of the target signal in the time axis direction. The shift part 376 shifts the target signal in the time axis direction according to a shift condition included in the setting information preset in the auxiliary storage apparatus 34. The shift condition is a condition for correcting a deviation in the time axis direction between the waveform of the target signal and a pattern (hereinafter, referred to as "comparison pattern") to be compared with the target signal in the comparison part 375a. The shift condition is, for example, a condition for matching the time of a characteristic portion of the waveform of the target signal with the time of a characteristic portion of the comparison pattern. The characteristic portion refers to only one or a few characteristic portions (for example, two or three) that occur in the target signal. Specific examples of the characteristic portion include a maximum value, a minimum value, and a zero cross point. The characteristic portion may be defined as the maximum value, the minimum value, or the zero cross point located between predetermined time intervals with reference to the signal start timing or the signal end timing, for example. The characteristic portion may be defined as the n^{th} maximum value, minimum value, or zero cross point that appears after the signal start timing, for example. Here, n is an integer equal to or greater than 1. The shift part 376 shifts the waveform of the target signal in the time axis direction so that the time of the characteristic portion of the waveform of the target signal matches the time of the portion in the comparison pattern corresponding to the characteristic portion.

The comparison part 375a compares the target signal shifted by the shift part 376 with the comparison pattern registered in advance in the auxiliary storage apparatus 34. The comparison pattern shows the threshold value at each time of the waveform of the target signal. A specific example of the comparison pattern will be described later.

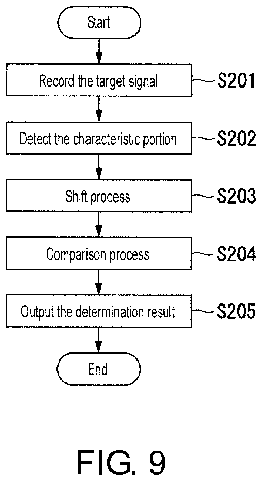

FIG. 9 is a flowchart showing an operation example of the control apparatus 3 according to the second embodiment. The flowchart shown in FIG. 9 shows a flow of the processing at the time when the control apparatus 3 performs the comparison process.

First, the recording part 371 executes the recording operation according to the recording start condition and the recording end condition stored in the auxiliary storage apparatus 34 (step S201). By executing the recording operation, the target signal is recorded in the RAM 36. The shift part 376 detects the characteristic portion in the target signal according to the shift condition stored in the auxiliary storage apparatus 34 (step S202). The shift part 376 shifts the target signal based on the detected characteristic portion (step S203). The comparison part 375 compares the shifted target signal with the comparison pattern corresponding to the comparison condition stored in the auxiliary storage apparatus 34 (step S204). The comparison part 375 performs the determination process according to the comparison result. The comparison part 375 outputs the determination result (step S205).

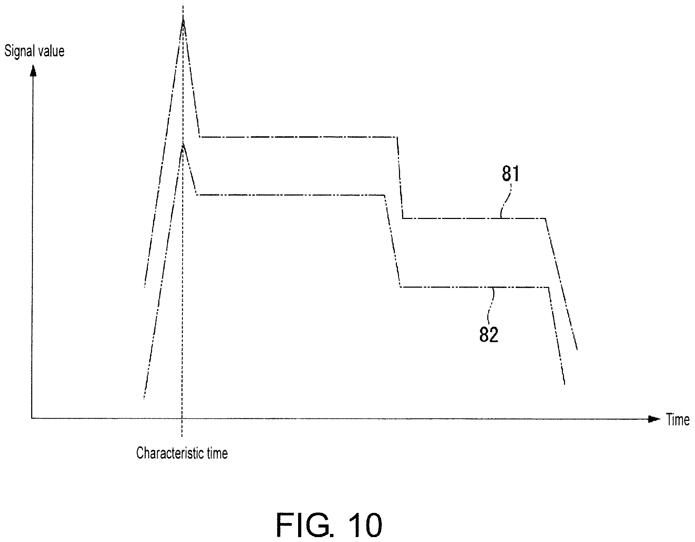

FIG. 10 is a diagram showing a specific example of the comparison pattern. The comparison pattern indicates an area of the threshold value relating to the determination result of the target signal. For example, the comparison pattern shown in FIG. 10 includes an upper limit waveform 81 which is a waveform showing the upper limit value at each time of the target signal, and a lower limit waveform 82 which is a waveform showing the lower limit value at each time of the target signal. In the comparison pattern, the time corresponding to at least one characteristic portion is predefined as a characteristic time. In the example of FIG. 10, the time corresponding to the maximum value is predefined as the characteristic time.

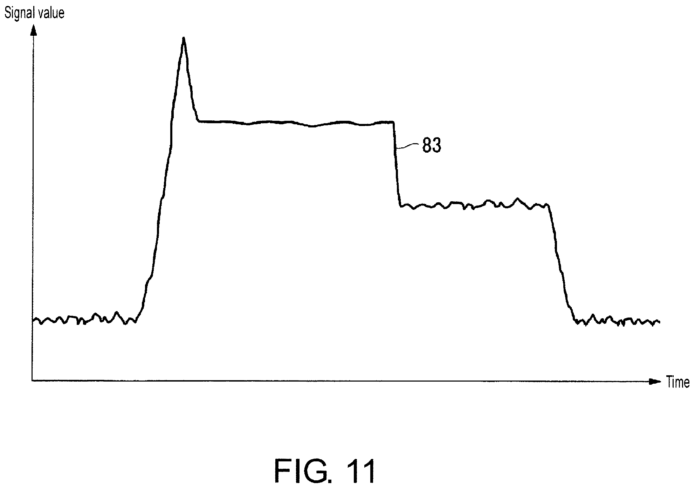

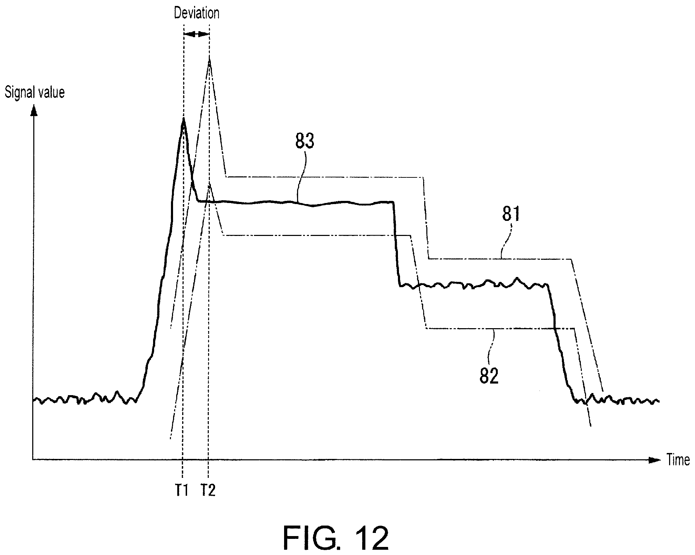

FIG. 11 is a diagram showing a specific example of the target signal. In FIG. 11, a waveform 83 indicates the waveform of the target signal. FIG. 12 is a diagram showing the comparison pattern and a target signal not shifted by the shift part 376 arranged on the same time axis. The comparison pattern shown in FIG. 12 is the comparison pattern shown in FIG. 10. The target signal shown in FIG. 12 is the target signal shown in FIG. 11. As shown in FIG. 12, a deviation in time occurs between the time T1 at which the characteristic portion appears in the target signal and the time T2 at which the characteristic portion appears in the comparison pattern. Due to this deviation, the value of the target signal compared with the comparison pattern is not an ideal value. For example, the value of the target signal (the value of the signal at the time T2) compared with the time T2 of the comparison pattern is lower than the lower limit waveform 82. Therefore, in the example of FIG. 12, the value of the target signal is not located between the upper limit waveform 81 and the lower limit waveform 82 and it is determined that the condition is not satisfied.

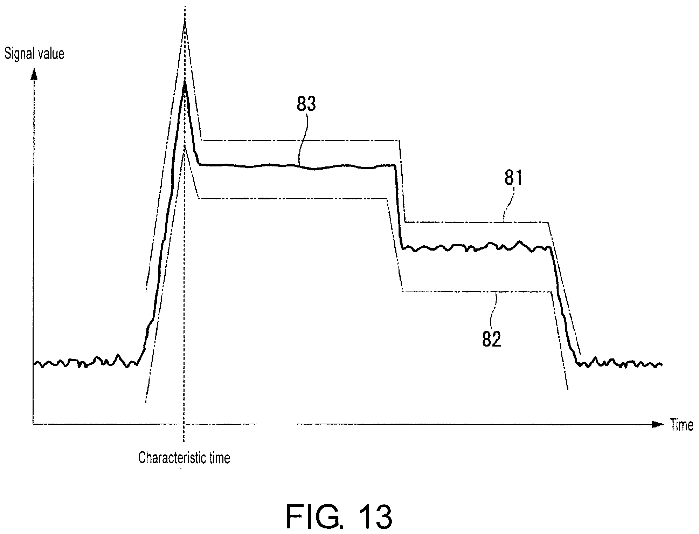

FIG. 13 is a diagram showing the comparison pattern and a target signal shifted by the shift part 376 arranged on the same time axis. The shift part 376 detects a characteristic portion satisfying the predefined condition in the waveform of the target signal. Then, the shift part 376 detects the time corresponding to the detected characteristic portion as the characteristic time and shifts the target signal. In FIG. 13, the target signal is shifted in the time axis direction so that the characteristic time of the target signal matches the characteristic time of the comparison pattern. The comparison part 375a compares the target signal that has been shifted as described above with the comparison pattern. For example, in the example of FIG. 13, the comparison part 375a compares to determine whether the signal value of the target signal is located between the upper limit value and the lower limit value at each time. If the signal value of the target signal is located between the upper limit value and the lower limit value at each time, the comparison part 375a may determine that the target signal is a correct target signal. For example, the object that obtains the target signal may be determined as an acceptable item.

In the control apparatus 3 according to the second embodiment configured as described above, the target signal is shifted so that the times of appearance of the characteristic portions of the target signal and the comparison condition match each other. Therefore, the deviation in the time axis direction between the target signal and the comparison condition can be reduced. Therefore, the comparison can be performed with high accuracy. Particularly, if the target signal or the comparison condition changes abruptly in the time axis direction, the comparison result may vary greatly due to a slight deviation in the time axis direction. However, in the control apparatus 3 according to the second embodiment, the deviation in the time axis direction can be reduced as described above. Thus, even if the target signal or the comparison condition changes abruptly in the time axis direction, the comparison can still be performed with high accuracy.

### (Modified Example)

In the first to third specific examples of the first embodiment, the comparison condition may be given as the upper limit value and the lower limit value of the signal value, for example. In that case, the comparison part 375 compares the value of the target signal in the target area with the upper limit value and the lower limit value. The comparison part 375 outputs a determination result according to whether the value is equal to or less than the upper limit value and equal to or greater than the lower limit value. For example, if the value of the target signal in the target area is equal to or less than the upper limit value and equal to or greater than the lower limit value, the comparison part 375 may output the result that the determination condition is satisfied.

In the control apparatus 3 of the first embodiment, the target signal is recorded by the recording part 371 to be acquired. However, the way the control apparatus 3 acquires the target signal is not limited to the recording performed by the recording part 371. For example, the control apparatus 3 may receive data of the target signal from another apparatus via any of the first communication module 31, the second communication module 32, and the third communication module 33. For example, if the AD conversion apparatus 2 has the function of recording the target signal, the control apparatus 3 may acquire the target signal by receiving data of the target signal from the AD conversion apparatus 2 via the first communication module 31.

In the second embodiment, the comparison condition (for example, the comparison pattern) may be shifted in the time axis direction, instead of the target signal.

### [Reference Signs List]

100: control system
11: first device
12: second device
13: timing input device
2: AD conversion apparatus
20: internal bus
21: analog input interface
22: AD converter
23: FPGA (field programmable gate array)
24: ROM (read only memory)
25: processor
26: communication module
3: control apparatus
30: internal bus
31: first communication module
32: second communication module
33: third communication module
34: auxiliary storage apparatus
35: buffer memory
36: RAM (random access memory)
37: processor 37
371: recording part
372: setting part
373: determination part
374: area determination part
375, 375 a: comparison part
376: shift part
4: terminal apparatus

## Claims

1. A control apparatus (3), **characterized by** comprising:
an acquisition part (32) acquiring a time series signal output from a device;
a comparison condition storage part (34) storing information indicating a temporal change of a predetermined comparison condition;
an area determination part (374) determining a target area, which is an area satisfying a predetermined condition indicating that change of a value is stable, in the signal acquired by the acquisition part (32); and
a comparison part (375) performing comparison with the comparison condition by using a signal of the target area determined by the area determination part (374).

2. The control apparatus (3) according to claim 1, wherein the area determination part (374) determines an area between a point of time at which a predetermined first time has elapsed since a beginning of the signal and a point of time at which a predetermined second time has elapsed since the beginning of the signal as the target area.

3. The control apparatus (3) according to claim 1, wherein the area determination part (374) determines an area from a point of time at which a condition indicating that change of the value of the signal is stable is satisfied for a predetermined time to a point of time at which the predetermined time has elapsed as the target area.

4. The control apparatus (3) according to claim 1, wherein the area determination part (374) determines an area from a point of time at which a condition indicating that change of the value of the signal is stable is satisfied for a predetermined time to a point of time at which the condition is not satisfied as the target area.

5. A control method for an apparatus, which comprises a comparison condition storage part (34) that stores information indicating a temporal change of a predetermined comparison condition, wherein the method is characterized to execute:
an acquisition step of acquiring a time series signal output from a device;
an area determination step of determining a target area, which is an area satisfying a predetermined condition indicating that change of a value is stable, in the signal acquired in the acquisition step; and
a comparison step of performing comparison with the comparison condition by using a signal of the target area determined in the area determination step.
